# EUROPÄISCHE PATENTSCHRIFT

(11) **EP 2 561 740 B1**
(45) Veröffentlichungstag und Bekanntmachung des Hinweises auf die Patenterteilung: **19.11.2014**
(21) Anmeldenummer: 11711492.6
(22) Anmeldetag: 15.03.2011
(51) Int. Cl.: H05K 7/20

(54) **LAMELLENGITTER**
LOUVERED GRILLE
GRILLE À LAMELLES

(30) Priorität: 19.04.2010 DE 102010016505
(43) Veröffentlichungstag der Anmeldung: 27.02.2013
(73) Patentinhaber: RITTAL GmbH & Co. KG, 35745 Herborn (DE)
(72) Erfinder: SCHNEIDER, Stefan, 35080 Bad Endbach (DE); WAGNER, Steffen, 57299 Burbach (DE); HARTMANN, Reiner, 35435 Wettenberg (DE)
(74) Vertreter: Tönhardt, Marion
(86) Internationale Anmeldenummer: PCT/EP2011/053898
(87) Internationale Veröffentlichungsnummer: WO 2011/131425

(56) Entgegenhaltungen:
- EP-A1- 2 152 052
- DE-U1-202006 005 673
- US-A- 2 820 407
- US-A- 2 851 981

## Beschreibung

Die Erfindung betrifft ein Lamellengitter zur Abdeckung von in Durchbrüchen von Schaltschränken montierten Luftführungsgehäusen mit einer Vielzahl von Lamellen, die zueinander unter Bildung von Luftdurchtrittsöffnungen beabstandet angeordnet sind, wobei sich die Lamellen in Lamellengitter-Breitenrichtung erstrecken und eine zur Außenseite hinweisende, quer zur LamellengitterHöhenrichtung geneigt verlaufende Lamellenbreite aufweisen. Dabei ist die Lamellenoberseite zumindest eines Teils der Lamellen sowohl in Lamellengitter-Breitenrichtung als auch in Lamellengitter-Höhenrichtung zumindest bereichsweise konvex gewölbt

Derartige Lamellengitter sind aus dem Stand der Technik vorbekannt. Dabei sind Lamellen verwendet, die geneigt in Lamellengitter-Breitenrichtung zwischen zwei Tragstegen verlaufen. Die Lamellengitter dienen zur Abdeckung von Luftführungsgehäusen, die in einen Durchbruch einer Schaltschrankwand eines Schaltschrankes eingesetzt sind. Die Lamellengitter decken das Luftführungsgehäuse nach außen hin ab, um einen gewissen mechanischen Zugriffschutz zu bieten. Über die geneigte Oberfläche der Lamellen kann Regenwasser abgeleitet werden, so dass es nicht in den Innenraum des Schaltschrankes gelangt. Über die sogenannte IP-Klassifizierung wird die Schutzarzt des Lamellengitters festgelegt. Dabei wird angegeben, welche Widerstandsfähigkeit das Lamellengitter zum einen eindringenden Gegenständen mechanisch und zum anderen eindringender Feuchtigkeit entgegensetzt. Wenn eine besonders hohe Schutzart gefordert ist, so ist es erforderlich, dass das Lamellengitter der Einwirkung eines Dampfstrahlers widersteht, der von der Außenseite her einwirkt.

Die EP 2 152 052 A1 beschreibt ein Gehäuse zum Unterbringen elektronischer Komponenten mit einem Lamellengitter für ein Luftführungsgehäuse, das eine Vielzahl von Lamellen aufweist, die zueinander unter Bildung von Luftdurchtrittsöffnungen beabstandet angeordnet sind. Dabei erstrecken sich die Lamellen in Lamellengitter-Breitenrichtung und weisen eine zur Außenseite hin weisende quer zur Lamellengitter-Höhenrichtung geneigt verlaufende Lamellenoberseite auf. Diese Lamellenoberseite ist bei zumindest einem Teil der Lamellen sowohl in Lamellengitter-Breitenrichtung als auch in Lamellengitter-Höhenrichtung zumindest bereichsweise konvex gewölbt.

Ein derartiges Lamellengitter ist außerdem aus der US 2,851,981 A bekannt. Hier ist ausdrücklich der Wetterschutz angesprochen, mit dem beschriebenen Lamellengitter soll das Eindringen von Regen, Schnee, Graupel und dergleichen verhindert werden. Ein derartiges Lamellengitter kann auch mit einer Filtermatte ausgestattet sein, die in einen Mattenhalter eingesetzt ist, wie aus der US 2,820,407 A hervorgeht.

Ein Lamellengitter, wie oben beschrieben, mit einer Filtermatte ist außerdem aus der DE 20 2006 005 673 U1 bekannt.

Es ist Aufgabe der Erfindung, ein Lamellengitter der eingangs erwähnten Art zu schaffen, mit dem hohe IP-Schutzarten, insbesondere im Hinblick auf den Widerstand gegen eindringende Feuchtigkeit, verwirklichbar sind.

Diese Aufgabe wird durch ein Lamellengitter nach Anspruch 1 gelöst. Vorteilhafte Ausgestaltungen sind Gegenstand der Unteransprüche. Die durch die doppelt konvex gebogene Oberfläche der Lamelle entstehende Balligkeit führt dazu, dass ein auftreffender Wasserstrahl eines Dampfstrahlers an der Lamelle zerstäubt wird, so dass er seine kinetische Energie verliert. Damit wird die Fähigkeit des Dampfstrahls gebrochen und die Gefahr von Eindringen von Wasser wird deutlich reduziert.

Gemäß einer bevorzugten Erfindungsvariante kann es vorgesehen sein, dass die Lamellen streifenförmig ausgebildet sind und ausgehend von ihrem Mittenbereich zu den längsseitigen Enden in Lamellengitter-Höhenrichtung abfallen. Auf diese Weise wird eine gebogene Lamellenform bereitgestellt, bei der von der Lamellenoberseite ablaufendes Wasser seitlich zu den Lamellenrändern geleitet wird. Damit lässt sich eine bessere Wasserableitung von den Lamellen und ein erhöhter IP-Schutz verwirklichen.

Eine weiter bevorzugte Erfindungsvariante ist derart, dass die Lamellen auf ihrer der Lamellenoberseite abgewandten Unterseite zumindest bereichsweise konkav ausgebildet sind. Diese konkave Geometrie bildet eine labyrinthartige Fließbarriere für das Wasser.

Um ein Eindringen von Wasser, welches beispielsweise von einem Dampfstrahler durch die zwischen den Lamellen gebildeten Durchtrittsöffnungen einwirkt, zu blockieren, sieht die Erfindung vor, dass die Lamellen auf ihrer Lamellenunterseite eine Sperrwand aufweisen, die im Winkel zur Lamellenunterseite steht und sich in Richtung zur Lamellengitter-Rückseite hin erstreckt. An dieser Sperrwand wird dem eindringenden Wasser ein Widerstand entgegengesetzt. Hierbei hat es sich als besonders vorteilhaft erwiesen, wenn die Sperrwand, ausgehend vom Lamellengitter-Mittenbereich eine größere Erstreckung in Richtung der Lamellengittertiefe aufweist, als an ihren längsseitigen Enden. Damit bildet die Sperrwand im Lamellengitter-Mittenbereich eine größere Wandhöhe, als im Seitenbereich. Diese Maßnahme verbessert zum einen die Widerstandsfähigkeit gegen eindringendes Spritzwasser, zum anderen wird die Lamelle in ihrem Mittenbereich, also dort, wo bei mechanischer Beanspruchung die größten Materialspannungen zu erwarten sind, effektiv ausgesteift.

Die Lamellen haben einen oberen, in Lamellengitter-Breitenrichtung verlaufenden, und einen unteren, ebenfalls in Lamellengitter-Breitenrichtung verlaufenden, Rand. Bevorzugterweise sind diese beiden Ränder als gebogene Konturen ausgeführt, wobei die Radien der beiden bogenförmigen Konturen unterschiedlich sind. Damit wird eine bessere Wasserstrahlabfuhr unterstützt. Zusätzlich bietet der untere gebogene Rand eine Tropfwasserkante, an der abfließende Wassertropfen zuverlässig abgeleitet werden können, ohne dass der durch die Lufttrittsöffnungen führende Luftstrahl die an der Tropfkante gebildeten Wassertropfen mitreißen kann.

Wenn vorgesehen ist, dass im Bereich der Rückseite der Lamellen eine Filtermatte angeordnet ist, die beabstandet von den Lamellen angeordnet ist, dann wird hinter den Lamellen ein Expansionsraum geschaffen. Wenn nun ein Wasserstrahl zwischen den Lamellen durch die Luftdurchtrittsöffnungen hindurch dringt, so wird er zwischen den Lamellen gebündelt gehalten und gelangt dann in den Expansionsraum. Hierbei entspannt er sich und verliert seine kinetische Energie. Die Filtermatte bietet dann ausreichende Widerstandsfähigkeit, um dem gebrochenen Wasserstrahl zu widerstehen. Diese Maßnahme unterstützt damit effektiv den IP-Schutz.

Wenn hierbei vorgesehen ist, dass auf der Lamellengitter-Rückseite ein Mattenhalter einteilig angeformt ist, in den die Filtermatte eingesetzt ist, dann wird mit einfachen konstruktiven Maßnahmen die Funktionalität des Lamellengitters erweitert. Der Mattenhalter legt die Filtermatte in Bezug auf die Lamellen definiert fest.

Eine weitere Funktionserweiterung kann dadurch erfolgen, dass an der Lamellengitter-Unterseite Scharnieraufnahmen angeformt sind. Mittels dieser Scharnieraufnahmen kann das Lamellengitter an Scharnierteilen des Luftfiltergehäuses angekoppelt. werden, wobei eine Scharnierachse entsteht, um die das Lamellengitter abgeklappt werden kann. Damit ist die Rückseite des Lamellengitters und die Innenseite des Luftfiltergehäuses zu Wartungszwecken zugänglich. Beispielsweise kann dann eine Filtermatte ausgetauscht werden. Dabei ergibt sich eine ansprechende optische Gestaltung, wenn vorgesehen ist, dass die Scharnieraufnahmen frontseitig mit einer, in Lamellengitter-Breitenrichtung verlaufenden Blende abgedeckt sind.

Weiterhin kann es vorgesehen sein, dass das Lamellengitter eine angeformte Griffaufnahme aufweist, in die ein Griff schwenkbar eingesetzt ist. Der Griff dient als Verriegelungshilfe, wenn das Lamellengitter in seiner aufgestellten Betriebsposition angeordnet ist. Mittels des Griffes kann das Lamellengitter entriegelt und beispielsweise über die Scharnierverbindung zum Luftfiltergehäuse in eine abgeklappte Montageposition bewegt werden.

Die Erfindung wird im Folgenden anhand eines in den Zeichnungen dargestellten Ausführungsbeispieles näher erläutert. Es zeigen:
- Figur 1: in perspektivischer Frontansicht ein Lamellengitter;
- Figur 2: das Lamellengitter gemäß Figur 1 in Frontansicht;
- Figur 3: ein in Figur 2 mit III - III dargestellter Schnittverlauf;
- Figur 4: ein in den Zeichnungen mit IV - IV dargestellter Schnittverlauf; und
- Figur 5: ein in der Figur 2 mit V - V dargestellter Teilschnitt.

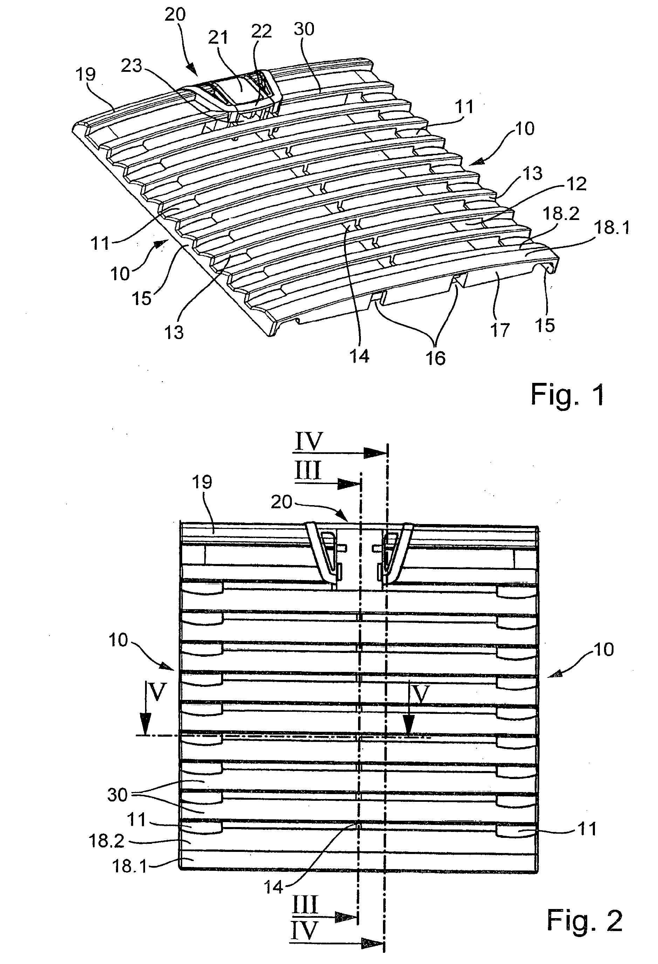

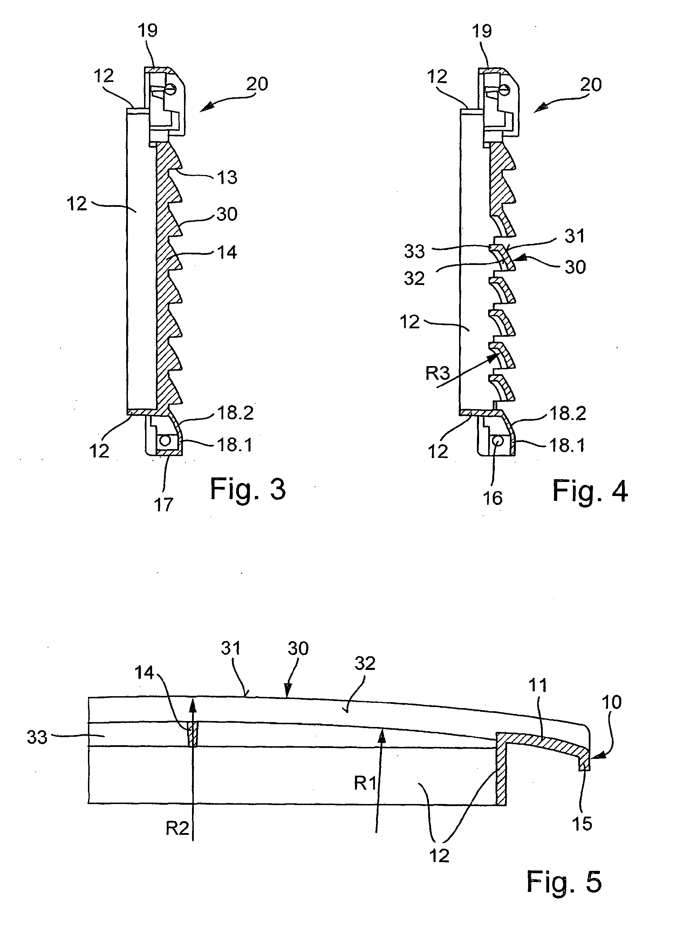

Figur 1 zeigt ein Lamellengitter, das zwei zueinander beabstandet angeordnete Seitenteile 10 aufweist. Wie Figur 5 erkennen lässt, weisen die Seitenteile 10 einen senkrecht zur Lamellengitter-Rückseite stehenden Wandabschnitt auf, der als Mattenhalter 12 ausgebildet ist. An diesen Mattenhalter 12 schließen sich konvex gewölbte Verbindungsabschnitte 11 an, die in abgewinkelten Seitenwänden 15 auslaufen. Die Seitenwände 15 stehen wieder parallel zu den Mattenhaltern 12.

Wie Figur 1 weiter erkennen lässt, verlaufen die Lamellen 30 zwischen den Seitenteilen 10. Sie erstrecken sich zwischen den Seitenteilen 10 in Lamellengitter-Breitenrichtung. Die Lamellen 30 sind als streifenförmige Materialabschnitte ausgebildet, die quer zur Lamellengitter-Höhenrichtung, also zur Lamellengitter-Rückseite, geneigt verlaufen. An ihren längsseitigen Enden sind die Lamellen 30 mittels vertikal zur Lamellengitter-Rückseite verlaufenden Wandungen 13 an die Verbindungsabschnitte 11 angekoppelt. An ihrem oberen Rand sind die Lamellen 30 unmittelbar an die Verbindungsabschnitte 11 angekoppelt. Zwischen den Lamellen 30 und den Seitenteilen 10 sind die Luftdurchtrittsöffnungen gebildet. Diese bilden eine luftleitende Verbindung zwischen der Lamellengitter-Rückseite und der Lamellengitter-Frontseite. Im Mittenbereich zwischen den beiden Seitenteilen 10 ist ein Steg 14 an die Lamellen 30 angeformt. Dieser verbindet die einzelnen Lamellen 30 miteinander und dient somit zur mechanischen Aussteifung. An dem oberen horizontalen Rand ist das Lamellengitter mittels eines Quersteges 19 mit konvex gewölbter Oberfläche abgeschlossen. Der Quersteg 19 verbindet die beiden Seitenteile 10. Am unteren horizontalen Rand des Lamellengitters ist ein weiterer Quersteg 18.2 angeordnet, der ebenfalls die beiden Seitenteile 10 miteinander verbindet. Der Quersteg 18.2 weist eine Blende 18.1 auf, die optisch Scharnieraufnahmen 16 zur Frontseite des Lamellengitters hin überdeckt. An der Blende 18.1 ist eine Abschlusswand 17 angeformt, die rechtwinklig zur Lamellengitter-Rückseite steht. Am oberen Randbereich ist in das Lamellengitter eine Griffaufnahme 20 eingeformt, in der ein Griff 21 eingerastet werden kann, wobei der Griff 21 dabei um eine horizontal verlaufende Schwenkachse gegenüber dem Lamellengitter zwischen einer Sperrstellung und einer Entriegelungsstellung verschwenkt werden kann. Der Griff 21 weist eine Handhabe 22 auf, die durch eine Griffmulde 23 hindurch zugänglich ist. An der Handhabe 22 kann der Griff 21 gegriffen und entriegelt werden.

In Figur 2 ist das Lamellengitter ohne den Griff 21 dargestellt, so dass die Griffaufnahme 20 deutlich erkennbar ist.

Figur 3 zeigt den in Figur 2 mit III - III gekennzeichneten Schnittverlauf. Wie aus dieser Darstellung ersichtlich ist, verbindet der Steg 14 als steife Wand sämtliche Lamellen 30 und ist an seinen längsseitigen Enden an den oberen und unteren Quersteg 19, 18.2 angekoppelt. Weiterhin ist aus dieser Darstellung erkennbar, dass der Mattenhalter 12 als umlaufender Rahmen von vier vertikal zur Lamellengitter-Rückseite stehenden Wandstücken gebildet ist. In den Mattenhalter 12 kann eine, in der Zeichnung nicht dargestellte, Filtermatte eingesetzt werden. Dabei stützt sich die Filtermatte mit ihrer Fronseite an dem Steg 14 ab und ist somit im Abstand zu den Rückseiten der Lamellen 30 gehalten.

In Figur 4 ist die Geometrie der Lamellen 30 näher veranschaulicht. Wie diese Darstellung erkennen lässt, weisen die Lamellen 30 eine Lamellenoberseite 31 und eine Lamellenunterseite 32 auf. Am oberen horizontalen Rand der Lamellen 30 ist eine Sperrwand 33 angeformt, die vertikal zur Lamellengitter-Rückseite steht und sich in Richtung zur Lamellengitterrückseite hin erstreckt. Zwischen den einzelnen Lamellen 30 sind die Luftdurchtrittsöffnungen gebildet. Wie Figur 4 weiter veranschaulicht, ist sowohl die Lamellenoberseite 31, als auch die Lamellenunterseite 32 gewölbt ausgebildet. Dabei ist die Lamellenoberseite 31 konvex und die Lamellenunterseite 32 konkav gestaltet. Die Lamellenoberseite 31 weist eine konkave Wölbung auf, die sich mit einem Querradius R3 in Lamellengitter-Höhenrichtung erstreckt, wie dies die Figur 4 veranschaulicht. Die Lamellenunterseite 32 weist eine konkave Wölbung auf, die sich ebenfalls in Lamellengitter-Höhenrichtung erstreckt. Zusätzlich zu dieser im Lamellengitter-Höhenrichtung verlaufenden konvexen Wölbungen der Lamellenoberseite 31 weisen die Lamellenoberseiten eine weitere Konvexität auf. Diese erstreckt sich in Lamellengitter-Breitenrichtung, wie dies die Figur 5 erkennen lässt. Dementsprechend weist die Lamellenoberseite 31 eine konvexe Wölbung auf, die als kreisförmige Biegung zwischen den Seitenteilen 10 verläuft. Dabei bilden, wie dies Figur 5 veranschaulicht, die oberen Ränder der Lamellen 30 eine Bogenkontur mit dem Innenradius Ri. Die unteren Ränder der Lamellen 30 bilden einen Kreisbogen mit dem Außenradius R2. Mit dem Außenradius R2 und dem Innenradius R1 sind die Lamellen 30 sowohl in Lamellengitter-Breitenrichtung konvex gewölbt, als auch in Lamellengitter-Höhenrichtung und es ergibt sich eine doppelt ballig konvexe Wölbung der Lamellen 30, die für eine radiale Zerstäubung eines senkrecht auftreffenden Wasserstrahles auf die Lamelle 30 sorgt und dadurch den IP-Schutz verbessert. Der IP-Schutz wird weiterhin mit der Sperrwand 33 verbessert. Wenn ein Wasserstrahl eines Dampfstrahlers durch die Luftdurchtrittsöffnungen geführt ist, so trifft er unmittelbar auf die Sperrwand 33 und wird hier gebrochen. Er verliert dabei seine Bewegungsenergie und kann von der in den Mattenhaltern 12 gehaltenen Filtermatte zuverlässig in Schwerkraftrichtung abgeführt werden. Dabei fließt das Wasser, wie dies Figur 4 erkennen lässt, die das Lamellengitter in seiner vertikalen Betriebsposition zeigt, in Schwerkraftrichtung ab und trifft auf den unteren horizontalen Mattenhalter 12. Dort ist zwischen der unteren horizontalen Lamelle 30 und dem konvex gewölbten Quersteg 18.2 eine Austrittsöffnung gebildet, durch die das abfließende Wasser über die Blende 18.1 zur Lamellengitter-Außenseite geführt wird. Wie die Figur 4 erkennen lässt, ist zur verbesserten Optik der Quersteg 18.2 in seiner Außenansicht an die Gestaltung der Lamellenoberseite 31 angepasst und mit einer identischen Kontur wie diese ausgeführt. Damit wird eine durchgängige Lamellenoptik erzielt.

## Patentansprüche

1. Lamellengitter zur Abdeckung von in Durchbrüchen von Schaltschränken montierten Luftführungsgehäusen mit einer Vielzahl von Lamellen (30), die zueinander unter Bildung von Luftdurchtrittsöffnungen beabstandet angeordnet sind, wobei sich die Lamellen (30) in Lamellengitter-Breitenrichtung erstrecken und eine zur Außenseite hin weisende quer zur Lamellengitter-Höhenrichtung geneigt verlaufende Lamellenoberseite (31) aufweisen, wobei die Lamellenoberseite (31) zumindest eines Teils der Lamellen (30) sowohl in Lamellengitter-Breitenrichtung (Außenradius (R2) bzw. Innenradius (R1)) als auch in Lamellengitter-Höhenrichtung (Querradius (R3)) zumindest bereichsweise konvex gewölbt ist, die Lamellen (30) auf ihrer Lamellenunterseite (32) eine Sperrwand (33) aufweisen, die am oberen horizontalen Rand der Lamellen (30) angeformt ist und im Winkel zur Lamellenunterseite (32) und vertikal zur Lamellengitter-Rückseite steht und sich in Richtung zur Lamellengitter-Rückseite hin erstreckt.

2. Lamellengitter nach Anspruch 1,
**dadurch gekennzeichnet,**
**dass** die Lamellen (30) streifenförmig ausgebildet sind und ausgehend von ihrem Mittenbereich zu den längsseitigen Enden (LamellengitterHöhenrichtung) in Schwerkraftrichtung abfallen.

3. Lamellengitter nach Anspruch 1 oder 2,
**dadurch gekennzeichnet,**
**dass** die Lamellen (30) auf ihrer der Lamellenoberseite (31) abgewandten Lamellenunterseite (32) zumindest bereichsweise konkav ausgebildet sind.

4. Lamellengitter nach Anspruch 1,
**dadurch gekennzeichnet,**
**dass** die Sperrwand (33) ausgehend vom Lamellengittermittenbereich eine größere Erstreckung in Richtung der Lamellengittertiefe aufweist, als an ihren längsseitigen Enden.

5. Lamellengitter nach einem der Ansprüche 1 bis 4,
**dadurch gekennzeichnet,**
**dass** die Lamellen (30) an ihren in Lamellengitter-Breitenrichtung verlaufenden Rändern eine gebogene Kontur aufweisen, wobei die Radien (Innenradius (R1) und Außenradius (R2)) der beiden bogenförmigen Konturen unterschiedlich sind,

6. Lamellengitter nach einem der Ansprüche 1 bis 5,
**dadurch gekennzeichnet,**
**dass** im Bereich der Rückseite der Lamellen (30) eine Filtermatte angeordnet ist, die beabstandet von den Lamellen (30) angeordnet ist.

7. Lamellengitter nach Anspruch 6,
**dadurch gekennzeichnet,**
**dass** auf der Lamellengitter-Rückseite ein Mattenhalter (12) einteilig angeformt ist, in den die Filtermatte eingesetzt ist.

8. Lamellengitter nach einem der Ansprüche 1 bis 7,
**dadurch gekennzeichnet,**
**dass** an der Lamellengitter-Unterseite Scharnieraufnahmen (16) angeformt sind.

9. Lamellengitter nach Anspruch 8,
**dadurch gekennzeichnet,**
**dass** die Scharnieraufnahmen (16) frontseitig mit einer in Lamellengitter-Breitenrichtung verlaufenden Blende (18.1) abgedeckt sind.

10. Lamellengitter nach einem der Ansprüche 1 bis 9,
**dadurch gekennzeichnet,**
**dass** es eine angeformte Griffaufnahme (20) aufweist, in die ein Griff (21) schwenkbar eingesetzt ist.

## Claims

1. A louvered grille for air conduction housings mounted in openings of switchgear cabinets, comprising a plurality of louvers (30) which are spaced apart from another to form air passage openings, wherein the louvers (30) extend in the widthwise direction of the louvered grille and have an upper louver face (31) that is directed to the exterior and inclined transversely with respect to the vertical direction of the louvered grille,
wherein the upper louver face (31) of at least some of the louvers (30) has a convex curvature in at least some areas thereof, both in the widthwise direction of the louvered grill (outer radius (R2) or inner radius (R1), respectively) and in the vertical direction of the louvered grille (transverse radius (R3)), the louvers (30) comprising a barrier wall (33) at the lower louver face (32) thereof, which barrier wall is fitted to the upper horizontal edge of the louvers (30) and is angled with respect to the lower louver face (32) and extends towards a rear side of the louvered grille.

2. The louvered grille of claim 1, **characterized in that** the louvers (30) are strip-shaped and, starting from a center portion thereof towards the longitudinal ends (vertical direction of the louvered grille), slope in the direction of gravity.

3. The louvered grille of claim 1 or 2, **characterized in that** the louvers (30) have, at a lower louver face (32) facing away from the upper louver face (31), a concave curvature in at least some areas thereof.

4. The louvered grille of claim 1, **characterized in that** the barrier wall (33), starting from the center portion of the louvered grille, has a larger dimension in direction of the depth of the louvered grille than at the longitudinal ends thereof.

5. The louvered grille of any of claims 1 to 4, **characterized in that** the louvers (30) have a curved contour at their edges extending in the widthwise direction, wherein the radii (inner radius (R1) and outer radius (R2)) of the two curved contours are different from another.

6. The louvered grille of any of claims 1 to 5, **characterized in that** a filter mat is provided in the region of the rear face of the louvers (30) which is spaced apart from the louvers (30).

7. The louvered grill of claim 6, **characterized in that** a mat holder (12) is integrally fitted to the rear face of the louvered grille, into which the filter mat is inserted.

8. The louvered grille of any of claims 1 to 7, **characterized in that** hinge seats (16) are fitted to the lower face of the louvered grille.

9. The louvered grille of claim 8, **characterized in that** the hinge seats (16) are covered by a screen (18.1) extending in the widthwise direction of the louvered grille at a front face thereof.

10. The louvered grille of any of claims 1 to 9, **characterized by** comprising a handle seat (20) into which a handle (21) is pivotally inserted.

## Revendications

1. Grille à lamelles destinée à masquer des boîtiers de circulation d'air montés dans les percées des armoires de commande, comportant une pluralité de lamelles (30), qui sont écartées les unes des autres en formant des ouvertures de circulation d'air, lesdites lamelles (30) s'étendant dans le sens de la largeur de la grille et comportant une face supérieure (31) orientée vers le côté extérieur et inclinée transversalement par rapport au sens de la hauteur de la grille, ladite face supérieure (31) d'au moins une partie des lamelles (30) comportant au moins par zones une courbure convexe tant dans le sens de la largeur de la grille (rayon extérieur (R2) ou rayon intérieur (R1)) que dans le sens de la hauteur de la grille (rayon transversal (R3)), les lamelles (30) comportant sur leur face inférieure (32) une paroi d'arrêt (33) qui est formée sur le bord horizontal supérieur des lamelles (30) et qui est disposée en angle par rapport à la face inférieure (32) des lamelles et verticalement par rapport la face arrière de la grille et s'étend vers la face arrière de la grille.

2. Grille à lamelles selon la revendication 1, **caractérisée en ce que** les lamelles (30) sont réalisées en forme de bandes et s'étendent en pente descendante dans le sens de la force de gravité depuis leur zone centrale vers les extrémités du côté longitudinal (sens de la hauteur de la grille).

3. Grille à lamelles selon la revendication 1 ou 2, **caractérisée en ce que** les lamelles (30), sur leur face inférieure (32) opposée à leur face supérieure (31), sont réalisées avec une courbure concave au moins par zones.

4. Grille à lamelles selon la revendication 1, **caractérisée en ce que** la dimension de la paroi d'arrêt (33) depuis la partie centrale de la grille vers la profondeur de la grille est plus grande qu'au niveau de ses extrémités du côté longitudinal.

5. Grille à lamelles selon l'une quelconque des revendications 1 à 4, **caractérisée en ce que** les lamelles (30) ont un contour incurvé au niveau de leurs bords qui s'étendent dans le sens de la largeur de la grille, les rayons (rayon intérieur (R1) et rayon extérieur (R2)) des deux contours incurvés étant différents.

6. Grille à lamelles selon l'une quelconque des revendications 1 à 6, **caractérisée en ce que** dans la zone de la face arrière des lamelles (30) est disposée une nappe filtrante qui est disposée à distance des lamelles (30).

7. Grille à lamelles selon la revendication 6, **caractérisée en ce qu'**un support de nappe (12), dans lequel est insérée la nappe filtrante, est réalisé d'un seul tenant sur la face arrière de la grille.

8. Grille à lamelles selon l'une quelconque des revendications 1 à 7, **caractérisée en ce que** des logements pour charnières (16) sont formés sur la face inférieure de la grille à lamelles.

9. Grille à lamelles selon la revendication 8, **caractérisée en ce que** les logements pour charnières (16) sont masqués du côté frontal par un cache (18.1) s'étendant dans le sens de la largeur de la grille à lamelles.

10. Grille à lamelles selon l'une quelconque des revendications 1 à 9, **caractérisée en ce qu'**elle comporte un logement pour poignée (20) formé sur ladite grille, dans lequel une poignée (21) est insérée de manière pivotante.
